# EUROPEAN PATENT APPLICATION

(11) **EP 4 439 178 A1**
(43) Date of publication of application: **02.10.2024**
(21) Application number: 23164991.4
(22) Date of filing: 29.03.2023
(51) Int. Cl.: G03F 7/20, G03F 7/24

(54) **SYSTEM AND METHOD FOR APPLYING NON-PRINTING INDICIA ON DIGITAL FLEXOGRAPHIC PRINTING PLATES THROUGH A NON-IMAGED MASK**

(71) Applicant: Esko-Graphics Imaging GmbH, 25524 Itzehoe (DE)
(72) Inventor: Sievers, Wolfgang, CH-8105 Regensdorf (CH)
(74) Representative: Jonas, Hans-Hermann

(57) **Abstract**

Systems and methods for creating non-printing indicia having a non-printing elevation above the floor of a flexographic printing plate. The method includes providing a photopolymer printing plate precursor (100) having a front side, a back side, and a Laser Ablateable Mask system (LAMs) layer (104) disposed over the front side, and disposing on the LAMs layer an oxygen barrier (111) having a pattern defining the non-printing indicia. The back side of the plate precursor is exposed to actinic radiation while the oxygen barrier remains disposed on the LAMs layer. Exemplary systems include the photopolymer printing plate precursor with LAMs layer, back side exposure system, and oxygen barrier, and may further include an ink applicator, such as an inkjet printer, a marking pen, a stamp, or a spray nozzle.

## Description

### BACKGROUND OF THE INVENTION

A typical flexographic (flexo) photopolymer plate workflow may comprise the following steps:
1. Processing image information, using a raster image processor, at a certain screen resolution to obtain an image file.
2. Using the processor, combining the image file with other image files to create an imaging job that covers a full photopolymer plate precursor format.
3. Imaging the image files onto a Laser Ablateable Mask system (LAMs) layer on top of a photopolymer plate precursor, by any of various methods known in the art, thereby creating a mask on top of the plate precursor.
4. Curing the rear side of the plate precursor, such as with UVA light, to build a floor of cured polymer.
5. Curing the photopolymer through the mask on top of the plate precursor, such as with UVA light.
6. Processing the plate precursor to remove non-cured polymer from the plate precursor, thereby forming the plate.
7. Optionally, drying the plate to remove solvent (typically not performed when a thermal process does the processing).
8. Finishing the plate, such as by applying UVA and UVC light.
9. Separating the different image files, such as by cutting the polymer plate into patches on a xy-cutting table.
10. Mounting one or more of the plate patches, each of which embodies one or more image files, to a printing press, such as on a printing press cylinder.
11. Printing physical images on a print-receiving substrate using the plate in a printing press.
12. Cleaning ink from the plate, removing the plate from the press, and storing it for future use, such as a reprinting job.

It should be noted that the term "plate precursor" may be used herein to refer to any form of the plate in process prior to achieving its final form ready to receive and transmit ink. In general, however, at least the relief structures of the finished plate take a near final form after the uncured polymer removal step, despite one or more additional processes remaining. At times, the term "plate" may also be used herein to refer to the plate precursor as a shorthand reference, but those of skill in the art will understood the actual state of the plate in the overall process.

Various methods have been described for applying non-printing information on the floor of a flexographic printing plate, for any one of various purposes, including but not limited to: identifying the plate, plate patch, or job, for tracking the plate, for branding the plate, for providing operating parameters for one or more of the process steps described above. Exemplary methods and types of indicia are disclosed in the following Applications and related equivalents all of which are incorporated herein by reference and are commonly-owned by the Applicant of this application:
- PCT Application Ser. No. PCT/EP2019/052536, published as WO2019192764A1, titled "METHOD FOR PERSISTENT MARKING OF FLEXO PLATES WITH WORKFLOW INFORMATION AND PLATES MARKED THEREWITH."
- PCT Application Ser. No. PCT/EP2019/073200, published as WO2020043875A1, titled "PHOTOSENSITIVE PRINTING FORM FOR A FLEXOGRAPHIC PRINTING METHOD COMPRISING VISIBLE AND NON-PRINTABLE INFORMATION, AND METHOD FOR PREPARING SUCH A PRINTING FORM"
- PCT Application Ser. No. PCT/EP2019/076922, published as WO2020156692A1, titled "SYSTEM AND PROCESS FOR PERSISTENT MARKING OF FLEXO PLATES AND PLATES MARKED THEREWITH"
- PCT Application Ser. No. PCT/EP2020/078112, published as WO2021069489A1, titled "SYSTEM AND PROCESS FOR PERSISTENT MARKING OF FLEXO PLATES AND PLATES MARKED THEREWITH,"
- PCT Application Ser. No. PCT/EP2022/080376, filed October 31, 2022, titled "SYSTEM AND PROCESS FOR PERSISTENT MARKING OF FLEXO PLATES AND PLATES MARKED THEREWITH," SUMMARY OF THE INVENTION

Many of the techniques described in the foregoing generally include creating structures on the plate floor by UV exposure through mask openings or by UV curing from the back side of a plate with image information in addition to or combination with routine UV back exposure. These techniques may typically involve extensive image processing to add image information onto the plate floor.

Accordingly, there remains a need in the art for simpler techniques providing non-printing information on the floor of a plate.

### SUMMARY

One aspect of the invention relates to a method for creating non-printing indicia on a flexographic printing plate, wherein the non-printing indicia comprising structures having a non-printing elevation above a floor of the plate. The method includes the steps of providing a photopolymer printing plate precursor having a front side, a back side opposite the front side, and a Laser Ablateable Mask system (LAMs) layer disposed over the front side; disposing on the LAMs layer an oxygen barrier having a pattern defining the non-printing indicia; and exposing the back side of the plate precursor to actinic radiation while the oxygen barrier remains disposed on the LAMs layer.

Embodiments of the method may include imaging the LAMs layer by laser ablating openings in the LAMs layer corresponding to a desired image to be formed by printing structures on the front side of the plate prior to the exposure step. Such an embodiment may further include, after or during the back side exposure step, performing a front side exposure step comprising exposing the photopolymer printing plate precursor to actinic radiation through the openings in the LAMs layer.

In some embodiments, the oxygen barrier may comprise a planar layer defining the pattern, such as a foil or a sticker, or the the oxygen barrier may comprise a 3-dimensional object having elevated relief structures defining the pattern with gaps between adjacent relief structures that allow airflow therebetween, wherein the 3-dimensional object is disposed on the LAMs layer with outward surfaces of the elevated relief structure facing the LAMs layer. Such a 3-dimensional object may comprise a portion of a finished printing plate having structures elevated above a floor thereof that define the pattern. Embodiments may also include disposing the oxygen barrier by applying a liquid fluid, such as oil, water, ink, or a combination thereof, to the LAMs layer. The liquid fluid may be applied between the LAMs layer and the 3-dimensional or planar object that defines the pattern. Or, the liquid fluid, as applied or after evaporation of a volatile component to leave a dried residue, may solely define the pattern. The liquid fluid may be applied using an inkjet printer or a spray nozzle, via a marking pen or a stamp, or by applying a stencil to the LAMs layer, applying the liquid fluid over the stencil, and removing the stencil.

The intensity and corresponding duration for the actinic radiation exposure step may be selected for improving or optimizing formation of the non-printing indicia relative to a operable intensity associated with a different (typically shorter) corresponding duration.

Another aspect of the invention relates to a system for creating non-printing indicia having a non-printing elevation above a floor of a flexographic printing plate. The system includes a photopolymer printing plate precursor having a front side, a back side opposite the front side, and a Laser Ablateable Mask system (LAMs) layer disposed over the front side; a back side exposure system configured to expose the back side of the plate precursor to actinic radiation; and an oxygen barrier having a pattern that defines the non-printing indicia disposed on the LAMs layer. The oxygen barrier may comprise a planar layer defining the pattern or a 3-dimensional object having elevated relief structures defining the pattern with gaps between adjacent relief structures that allow airflow therebetween, wherein the 3-dimensional object is disposed on the LAMs layer with outward surfaces of the elevated relief structure facing the LAMs layer.

In some embodiments, the system may further include a liquid fluid disposed between the LAMs layer and the outward surfaces of the elevated relief structure of 3-dimensional object. In other embodiments, the oxygen barrier comprises a liquid fluid or a dried residue remaining from a liquid fluid from which a volatile component has evaporated. The system may further include an applicator for applying the liquid fluid, such as an inkjet printer, a marking pen, a stamp, or a spray nozzle. Some embodiments may include an inkjet printer having a print head mounted on a carriage of an exposure system. In other embodiments, the system may include an inkjet printer comprising a print head mounted on an imaging system.

### BRIEF DESCRIPTION OF THE DRAWINGS

FIG. 1 schematically depicts a flexographic, photopolymer plate precursor undergoing an exemplary back-exposure step.
FIG. 2 depicts an exemplary 3-dimensional relief structure suitable for use as an oxygen barrier in an embodiment of the invention.
FIG. 3 is a photograph of a finished printing plate embodying both printing structures as well as non-printing indicia formed in accordance with an embodiment of the invention.
FIG. 4 is a schematic drawing of an exemplary drum imaging system embodiment.
FIG. 5 is a schematic drawing of an exemplary flatbed imaging system embodiment.

### DETAILED DESCRIPTION OF THE INVENTION

Described herein are methods, apparatus, and systems for applying non-printing indicia onto the floor of a digital flexographic printing plate during UV exposure on a UV exposure system by blocking oxygen diffusion into the plate through the Laser Ablate able Mask system (LAMs). Such methods may be particularly well suited in systems configured for of exposing plates to front and back-side exposure simultaneously (i.e. with a predetermined delay between front and back exposure) and for providing additional back-exposure steps, such as systems described in PCT/EP2018/057060, published as WO2018/172374A1, titled PROCESS AND APPARATUS FOR ADJUSTING THE FLOOR OF A FLEXOGRAPHIC PRINTING PLATE IN A CONTROLLED EXPOSURE SYSTEM OR PROCESS, incorporated herein by reference. It should be understood, however, that the system as described herein is not limited to use in connection with any particular exposure systems or methods. For example, the principles as described herein may also be adapted for us in backside-only exposure systems that provide sufficient access to oxygen from the front side of the plate. For example, but without limitation, systems that may be particularly suitable for practicing aspects of the invention may include the Esko^{®} XPS, the XSYS ThermoFlexX Catena-E system, and certain bank exposure systems having one bank of tubes for front and another bank for back exposure (such as, e.g., a Cyrel^{®} 3000 ETL-I system).Aspects of the invention relate to the creation of non-printing structures on the plate floor by placing an oxygen-blocking barrier on top of the LAMs layer of a digital flexographic printing plate. Unlike prior art solutions that may require extensive image processing to add image information onto the plate floor, exemplary methods as described herein utilize relatively simple tools like stamps or stencils that apply or admit the application of an oxygen blocking ink or other oxygen blocking liquid fluid to the LAMs layer of the printing plate. As the process can be applied without the need of penetrating or removing the LAMs, it can be easily performed as an additional step, particularly on non-imaged portions of the plate (e.g. edge areas not intended for transferring ink to the substrate in a printing step), after the plate has been imaged.

Aspects of the invention may be utilized to provide Plate ID information, such as brand logos or watermarks with plate information, such as production day or customer name, on the plate. The invention is not limited to any specific content for the non-printing indicia so created, but exemplary content may include alphanumeric characters, non-text graphics, machine readable code, one or more lines, or a combination thereof, some or all of which may be in a repeating pattern. The non-printing indicia in any of the foregoing forms may embody information including job number, separation color, version, date, or a combination thereof. The indicia may comprise branding information. In some embodiments, the non-printing indicia may comprise alignment indicia for orienting the plate relative to the element of plate processing equipment.

Although certain indicia have been explicitly described, the term "indicia" is intended to have its broadest meaning of "an indication" or "distinguishing mark," without limitation to how that indication or mark is capable of being read, and thus the "equivalents" of the indicia as expressly described are intended to be broadly construed. While certain machine-readable indicia or codes may take advantage of formats that are exclusively machine readable to permit a large volume of information to be stored in a small amount of space, it should be understood that the term "machine readable," as used herein to refer to indicia and codes, is not limited to indicia having a format that is exclusively machine-readable. Those of skill in the art will appreciate that human readable alphanumeric information is also machine readable by a reader equipped with suitable optical character recognition (OCR) functionality, and that the hardware and software for providing such functionality is well known in the art. Machine vision systems and human operators alike can also be trained to read non-alphanumeric graphic symbols to convey information that can be universally understood (e.g. the graphic symbols denoting recyclable materials or laundry care recommendations). Thus, it should be understood that the terms "indicia" and "machine readable" are intended to be broadly interpreted to include, without limitation, in addition to the other types of indicia discussed in detail herein, printed or otherwise visible alphanumeric or graphical information configured to be read and comprehended by human operators as well as machines, as well as combinations of indicia that are exclusively machine readable with indicia that is both human and machine readable. One advantage of using machine-readable indicia that is also at least partially human readable, is that an experienced human operator may be able to process and act upon at least some codes faster than it would take that same operator to enlist the assistance of a machine.

In some embodiments, process information may be stored directly or indirectly in the indicia, such as may be embodied in a QR code, although indicia used for providing such information is not limited to any particular type of code. In particular, at least one variable operating parameter may be embodied in the indicia or stored in computer memory at a unique, machine-accessible address embodied in the indicia. In embodiments, process parameters for one or more stages of plate processing are embodied directly in the code such that each individual processing unit can derive instructions directly from the code on the plate without having to connect to a network. In other embodiments, the code may comprise a computer storage address where such process information is stored and may be used in conjunction with a reader configured to read the information embodied in the indicia, connect to the storage address embedded in the information such as via a hyperlink, read the information from the storage address, and communicating relevant stored information to the processing machine.

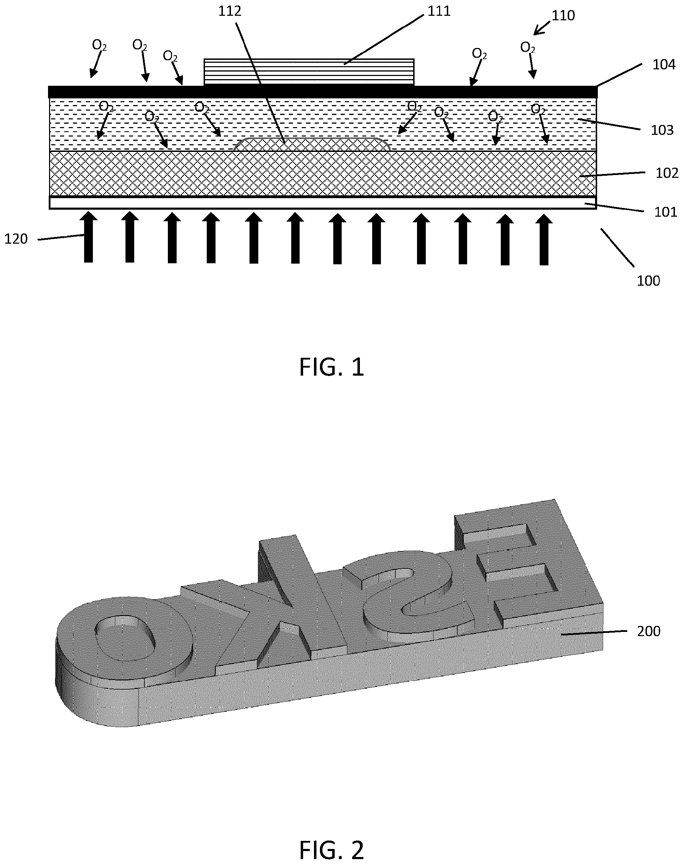

Without being held to any particular theory of operation, it is believed that the mechanism operative to perform the method entails blocking the entrance of oxygen from the surrounding air into the photopolymer during backside curing. This principle is depicted in FIG. 1.

FIG. 1 depicts a flexographic, photopolymer plate precursor 100, comprising dimensionally stable backside foil 101, photopolymer layer 102 to be cured by actinic radiation 120 to build the plate floor after the plate has been completely processed, another layer of non-cured polymer 103 that is removed during processing except for cured portions thereof that form relief structures elevated above the floor of the plate, and the LAMs layer 104 disposed over the non-cured polymer. As is known in the art, laser ablation of the LAMs layer in an imaging step and subsequent front side curing of photopolymer 103 in a subsequent front side curing step results in cured portions of the photopolymer corresponding to a desired image, which cured portions remain in the uncured polymer removal step to create relief structures. Relief structures having a printing elevation are configured to receive ink, whereas relief structures having a non-printing elevation may be used for support of printing structures or as non-printing indicia, as described in the background section herein. It should be noted that while specific methods for forming some non-printing indicia are disclosed and described in detail herein, this disclosure does not preclude the use of other methods for forming other non-printing indicia on the same plate.

Under normal operation, it is believed that free oxygen molecules 110 from the surrounding air tend to diffuse into the plate through the LAMs layer 104 during UV exposure from the plate back side by actinic radiation 120. This process is related to the oxygen inhibition of the polymer-chain reaction that consumes oxygen inside the plate as the oxygen terminates polymer chains. As the oxygen content inside the plate depletes during curing, new oxygen from the surrounding air migrates into the polymer and is available for further polymer chain termination. The movement of oxygen in the plate occurs at a certain speed, which limits the availability of oxygen from the plate environment during the curing process.

When an oxygen-barrier 111 is placed on top of the LAMs layer 104, not all areas of the polymer can be supplied with oxygen from the environment during the backside curing process. This creates a lack of oxygen over areas adjacent to the oxygen barrier. Thus, the floor in areas beneath the oxygen barrier on the LAMs layer grows slightly higher compared to areas not beneath an oxygen barrier. Accordingly, oxygen barriers defining one or more patterns that form alphanumeric letters, numbers, or codes thus may be used for creating three-dimensional, non-printing structures on the plate floor.

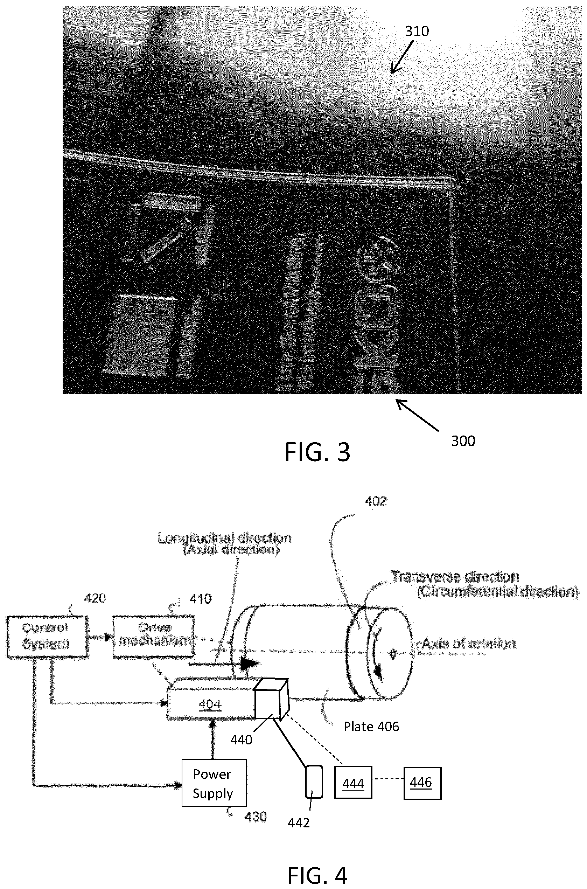

FIG. 2 depicts a three-dimensional Esko logo 200 (i.e. four letters in stylized form that are arranged to form the brand name "Esko"), printed on a 3-D printer. FIG. 3 is a photograph of structures having a printing elevation of about 0.54 mm at or near the top of the plate in the form of a first Esko logo 300, and a second Esko logo 310 formed by structures having a non-printing elevation of about 25 µm. In the example shown in FIG. 3, the plate is an NEF 114 (i.e. 1.14 mm thick) plate with a floor thickness (including the back side substrate) of 0.6 mm.

Various tools or devices may be used for creating the oxygen barriers in the form of desired patterns on the LAMs layer. In some embodiments, the non-printing indicia may be applied through non-imaged portions of the LAMs during a UV back exposure step, such as for example, by placing an already-fully-processed flexo plate with the printing side facing the LAMs layer. In this embodiment, the relief formed between the printing structures and floor, with the printing structures disposed adjacent the LAMs layer, create gaps into which the oxygen can flow during processing. In another embodiment, 3D structures (e.g. 3D printed structures) may be placed with the flat side created by the printing bed disposed adjacent the LAMS. Oxygen barriers may also be disposed as planar layers using marker pens, metal foils, stickers, or by applying oxygen blocking liquid fluid. In some cases, the oxygen-blocking fluid, such as oil, water, or ink may be used for improving the oxygen-blocking effect of three-dimensional objects, such as the object depicted in FIG. 2, when the contact surface of the object is slightly wettened with the fluid. In other embodiments, the oxygen-blocking fluid may solely form the oxygen barrier. The oxygen-blocking fluid may be applied as a liquid that dries. The term "liquid" as used herein refers to any non-gas fluid, and may refer to fluids that also contain particulates or non-liquid components, such as fluids comprising a volatile component, such that the applied liquid evaporates, leaving only a dry residue. In embodiments, the oxygen blocking fluid may be applied with a stamp, through openings in a stencil, or by inkjet printing or ink spraying. As is known in the art, a stencil is a type of mask typically comprising a planar sheet with openings therein, and an exemplary process comprises applying the stencil to the surface of the LAMs layer, applying the fluid over the stencil so that the fluid becomes disposed on the LAMs layer in the areas defined by the stencil, and then removing the stencil. It should be understood that the term "stencil" as used herein is not limited to any particular type of mask construction and may be interpreted to refer to any type of temporary mask that is applied during a fluid application step, and then removed.

An exemplary method and system may include using a stamp bearing the production date or production site name that places oxygen blocking ink on the LAMs, preferably in a predetermined, repeatable area. The stamp may be manually applied by a human user or applied automatically by a machine. Another exemplary method and system may include using an inkjet head (for example, mounted on a same movable carriage as a front exposure head in an exposure system or inside a digital imager for laser-ablating the LAMs layer), which prints information on the LAMs layer with oxygen-blocking ink.

FIG. 4 depicts an exemplary drum (e.g. imager) embodiment. As is known in the art, such imagers typically comprise a drive mechanism 410 (such as a motor and a transmission system, including gearing, belt drives, or the like, not shown) rotate drum 402 in a transverse, circumferential direction about an axis of rotation and advances a carriage 404, on which is mounted the imaging apparatus (e.g. a laser for ablating the LAMs layer). The carriage moves in a longitudinal (axial) direction parallel to the drum rotation axis, controlled by control system 420 and powered by power supply 430. Printing plate 406 may be in the form of a sleeve, or may be rectangular sheet, with the drum configured to hold opposite edges of the sheet in place with any one of various clamping systems known in the art, while the drum rotates. The mechanisms and details of operation of such imaging systems is well known in the art and not explained here further. In accordance with aspects of the invention, an additional inkjet printhead 440 is also disposed on the carriage and connected to a source of oxygen-blocking ink 442 and a controller 444 for controlling the deposition of oxygen-blocking ink in accordance with the printhead location based upon instructions stored in memory 446 (e.g. an the form of an image defining where ink should and should not be applied), which instructions (e.g. image) corresponds to the desired non-printing indicia as described herein. Although shown attached to the same carriage as the imaging system in FIG. 4, it should be understood that other embodiments may feature a dedicated carriage for the inkjet head or even a dedicated drum and inkjet configuration without the imaging components. In embodiments in which the non-printing indicia is intended to be located in only a specific area, the carriage bearing the inkjet head may have a travel limited to a portion of the plate less than the full area of the plate (e.g. less than the full longitudinal dimension of the plate.

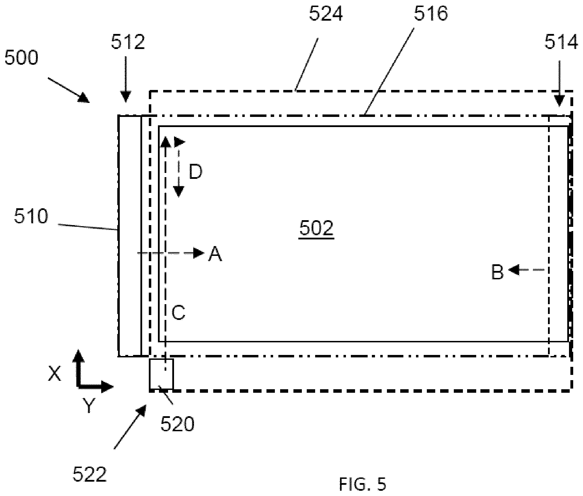

FIG. 5 depicts a plan view of an exemplary exposure system embodiment 500 comprising a substrate 502 (i.e. typically glass through which back-side exposure is transmitted) for holding the plate. Carriage 510 is configured to traverse the substrate along the X direction along arrow A in a first path from a first position 512 to a second position 514, and then return back to the first position in the direction of arrow B in a second path. Thus, the envelope of travel of carriage 510 is outlined by box 516 marked by a first style of dashed lines. Typically, front exposure actinic radiation is emitted during the traversal in the first path, but not during the traversal in the second path. In some embodiments, the front side and back side exposure systems are linked to one another and are spaced apart a predetermined distance to cause the back exposure to be followed by a predetermined, repeatable delay before the front back exposure, and/or may be configured to perform one or more back-exposure only steps, as is further described in U.S. Pat. No. 10,732,507, titled PROCESS AND APPARATUS FOR CONTROLLED EXPOSURE OF FLEXOGRAPHIC PRINTING PLATES AND ADJUSTING THE FLOOR THEREOF, commonly owned by the applicant of the present application and incorporated herein by reference. The present disclosure is not limited to any particular exposure method or system, and the details of various exposure systems are well known in the art and are not detailed further herein.

Embodiments of the invention as described herein include inkjet printer head 520 connected to a source of ink (not shown) and configured to scan the plate along the X and Y direction in a rastering fashion along the path of arrows C and D starting from a storage position 522, moving within the envelope defined by box 524 (marked by dashed lines different than those of box 516) in accordance with instructions provided by a control mechanism (not shown) guided as to where to dispense the oxygen-blocking ink in accordance with instructions stored in memory (not shown). In a typical method, after the oxygen blocking ink has been applied, backside exposure is provided from underneath exposure glass 502, and then frontside exposure is provided. There may be a predetermined, repeatable delay between the back side and front side exposure, or the back side exposure step may be independent of the front side exposure. Although not shown in FIG. 5, the source of ink, controller for the inkjet print head, and memory for storage of instructions may be configured in the same manner as depicted schematically in FIG. 4. Although shown as a separate carriage in FIG. 5, it should be understood that the inkjet head may be disposed on the same structure as the exposure head, particularly in systems with rastering front exposure heads, such that the front exposure head and inkjet print head move in tandem, typically with only one of the exposure head or inkjet head operational at a time.

The exemplary systems depicted in FIGS. 4 and 5 are only exemplary, and the invention is not limited to any particular structure for mounting the fluid applicator to a drum or flatbed system, or to any particular type of fluid applicator.

The photopolymer curing process is often a competition between polymer chain growth and oxygen inhibition. Therefore, the effect described herein may be controlled or influenced by the amount of UV energy provided within a given time. As is known in the art, UV energy intensity and exposure time typically have an inverse ratio to one another wherein as one increases, the other decreases. Decreasing the backside UV intensity such that curing takes relatively longer will make the effect for forming non-printing indicia as described herein stronger (i.e. the non-printing indicia have a greater elevation above the floor and are thus more visible), whereas applying backside curing energy at a relatively higher intensity for a relatively shorter period of time will reduce the effect of oxygen migration and result in a lesser effect.

The oxygen permeability of the LAMs layer also affects the visibility of the created non-printing structures. A LAMs layer that is generally not permeable to oxygen, or plate constructions having dedicated additional oxygen barrier layers, will prevent or lessen the effect, whereas LAMs layers having relatively good permeability will support the effect.

The plate thickness also has an impact on the strength of the effect. Relatively thin plates, such as 1.7, 1.14, or 0.76 mm thick flexo plates obtain respectively increasingly visible effects of the methods described herein, all other conditions remaining the same, whereas relatively thicker plates demonstrate less visible effects. Systems having relatively unfavorable conditions for creating the effects described herein may benefit from providing relatively larger patterns corresponding to the indicia to be created on the floor for improved visibility, as compared to the size of patterns used in systems with more favorable conditions.

Although the invention is illustrated and described herein with reference to specific embodiments, the invention is not intended to be limited to the details shown. Rather, various modifications may be made in the details within the scope and range of equivalents of the claims and without departing from the invention.

## Claims

1. A method for creating non-printing indicia on a flexographic printing plate, the non-printing indicia comprising structures having a non-printing elevation above a floor of the plate, the method comprising the steps of:
(a) providing a photopolymer printing plate precursor having a front side, a back side opposite the front side, and a Laser Ablateable Mask system (LAMs) layer disposed over the front side;
(b) disposing on the LAMs layer an oxygen barrier having a pattern defining the non-printing indicia; and
(c) exposing the back side of the plate precursor to actinic radiation while the oxygen barrier remains disposed on the LAMs layer.

2. The method of claim 1, further comprising:
(a1) imaging the LAMs layer by laser ablating openings in the LAMs layer corresponding to a desired image to be formed by printing structures on the front side of the plate;
wherein step (a1) is performed before step (c).

3. The method of claim 2, further comprising, after or during step (c):
(d) performing a front side exposure step comprising exposing the photopolymer printing plate precursor to actinic radiation through the openings in the LAMs layer.

4. The method of any of the foregoing claims, wherein the oxygen barrier comprises a planar layer defining the pattern, optionally wherein the planar layer comprises a foil or a sticker.

5. The method of any one of claims 1-4, wherein the oxygen barrier comprises a planar layer defining the pattern, wherein the oxygen barrier comprises a 3-dimensional object having elevated relief structures defining the pattern with gaps between adjacent relief structures that allow airflow therebetween, wherein the 3-dimensional object is disposed on the LAMs layer in step (b) with outward surfaces of the elevated relief structure facing the LAMs layer.

6. The method of claim 5, wherein the 3-dimensional object comprises a portion of a finished printing plate having structures elevated above a floor thereof that define the pattern, optionally wherein disposing the oxygen barrier includes applying a liquid fluid to the LAMs layer.

7. The method of claim 6, wherein the liquid fluid comprises oil, water, ink, or a combination thereof.

8. The method of claim 6, comprising applying the liquid fluid between the LAMs layer and a 3-dimensional or planar object that defines the pattern.

9. The method of claim 6, wherein the liquid fluid, either as applied or after evaporation of a volatile component to leave a dried residue, solely defines the pattern, optionally comprising applying the liquid fluid with an inkjet printer, a spray nozzle, a marking pen, a stamp, and/or by applying a stencil to the LAMs layer, applying the liquid fluid over the stencil, and removing the stencil.

10. The method of any of the foregoing claims comprising selecting an intensity and corresponding duration for the actinic radiation applied in step (b) for improving or optimizing formation of the non-printing indicia relative to an operable intensity associated with a shorter corresponding duration.

11. A system for creating non-printing indicia on a flexographic printing plate, the non-printing indicia comprising structures having a non-printing elevation above a floor of the plate, the system comprising:
a photopolymer printing plate precursor having a front side, a back side opposite the front side, and a Laser Ablateable Mask system (LAMs) layer disposed over the front side;
a back side exposure system configured to expose the back side of the plate precursor to actinic radiation; and
an oxygen barrier having a pattern that defines the non-printing indicia disposed on the LAMs layer.

12. The system of claim 11, wherein the oxygen barrier comprises a planar layer defining the pattern, optionally, wherein the oxygen barrier comprises a 3-dimensional object having elevated relief structures defining the pattern with gaps between adjacent relief structures that allow airflow therebetween, the 3-dimensional object disposed on the LAMs layer with outward surfaces of the elevated relief structure facing the LAMs layer.

13. The system of claim 12, further comprising a liquid fluid disposed between the LAMs layer and the outward surfaces of the elevated relief structure of 3-dimensional object

14. The system of claim 11, wherein the oxygen barrier comprises a liquid fluid or a dried residue remaining from a liquid fluid from which a volatile component has evaporated, optionally wherein the system further comprises an applicator configured for applying the liquid fluid, wherein the applicator is selected from the group consisting of: a marking pen, a stamp, and a spray nozzle.

15. The system of claim 11, wherein the oxygen barrier comprises a liquid fluid or a dried residue remaining from a liquid fluid from which a volatile component has evaporated, optionally wherein the system further comprises an applicator configured for applying the liquid fluid, wherein the applicator comprises an inkjet printer comprising a print head mounted on a carriage of an exposure system or a print head mounted on an imaging system.
